(19) Europäisches Patentamt
European Patent Office
Office européen des brevets

(11) **EP 3 879 282 B1**

(12) **EUROPEAN PATENT SPECIFICATION**

(45) Date of publication and mention
of the grant of the patent:
**09.07.2025 Bulletin 2025/28**

(21) Application number: **20161905.3**

(22) Date of filing: **09.03.2020**

(51) International Patent Classification (IPC):
**G01R 27/26** (2006.01)   **G01R 31/34** (2020.01)
**G01R 31/72** (2020.01)

(52) Cooperative Patent Classification (CPC):
**G01R 31/346; G01R 27/2617; G01R 31/72;**
G01R 31/52

(54) **EARLY DETECTION OF INSULATION FAILURE FOR ELECTRIC GENERATORS**

FRÜHERKENNUNG VON ISOLATIONSFEHLERN FÜR ELEKTRISCHE GENERATOREN

DÉTECTION PRÉCOCE DE DÉFAILLANCE D'ISOLATION POUR GÉNÉRATEURS ÉLECTRIQUES

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**15.09.2021 Bulletin 2021/37**

(73) Proprietor: **Siemens Gamesa Renewable Energy
A/S
7330 Brande (DK)**

(72) Inventors:
• **Freire, Nuno Miguel Amaral
7330 Brande (DK)**
• **Samanta, Subhra
7430 Ikast (DK)**
• **Wu, Zhan-Yuan
Sheffield, S10 4BB (GB)**

(74) Representative: **SGRE-Association
Siemens Energy Global GmbH & Co. KG
SE I IM P Intellectual Property
Siemenspromenade 9
91058 Erlangen (DE)**

(56) References cited:
**US-A1- 2005 218 906     US-A1- 2014 084 937
US-A1- 2017 219 655     US-A1- 2018 011 133**

## Description

Field of the invention

The invention relates to a stator of an electric generator including an electrical arrangement for detecting a failure of the insulation of the stator windings. The invention further related to a method for detecting a failure of the insulation of the stator windings. Particularly, but not exclusively, the present invention relates to a direct drive generator for a wind turbine.

Art background

The stator insulation system in an electric generator is a sensitive area, which degrades due to thermal, electrical, mechanical as well as environmental stress over time and eventually can have short circuit failure between windings and stator lamination or ground. Due to errors in workmanship or bad material quality also premature failures may occur. Most of the time such failures need extensive onsite repair or the exchange of a stator element. In large electrical machines, a circumferential segmentation of the stator may be required to ease manufacturing and transportation. Each stator segment may be configured to cover for example an arc of 30, 60, 90, 120 degrees (or any other angle) along the circumferential direction of the stator. The stator segments are circumferentially joined to form the stator (for example a stator may comprise six stator segments, each covering an arc of 60 degrees). Each stator segment comprises respective windings. Failures in the insultation system of the segment windings may require the exchange of the entire respective stator segment.

If such failures could be detected in an early stage of the failure inception, turbine outage time period could be minimized. In most cases secondary damages, which are experienced due to the incapacity to detect primary damages (main failure mode), could be avoided.

US 2018/011133 A1 discloses an insulation detection and compensation circuit for a rotating machine.

It is desirable that the detection of overall insulation degradation as well as of the location of the insulation damage is performed before short circuit faults occur and develop. At the same time, it is desirable that this is performed with as low as possible hardware requirements, in order to limit costs of the installation. It is further desirable that a continuous monitoring could be established, which provides the above described valuable information.

Summary of the invention

It may be an object of the present invention to provide an apparatus and a method, in particular to be used for an electric generator of a wind turbine, which permits to monitor the health status of the insulation of the stator windings of the electric generator. It may be a further object of the present invention to detect a failure in an electric generator that is due to defects (which may be caused by degradation or material defects or workmanship errors) of the insulation of the stator windings at an early stage, in order to be able to plan repair or replacement of defective elements in advance.

This objective may be solved by an apparatus and a method for determining a status of the insulation of an electrical circuit in an electric generator according to the subject matter of the independent claim.

The invention relates to an electric generator for a wind turbine including a stator having one or more segments circumferentially extending about a longitudinal axis of the stator, an electrical circuit associated with said segments, the electrical circuit including at least a coil winding wound on one of said segments the coil winding including an insulation. The electrical circuit comprises at least one current sensor for measuring a current flowing in the electrical circuit. The electric generator includes a controller for receiving a current measurement from said current sensor, calculating parameters depending on an impedance of at least a portion of said electrical circuit, determining a status of the insulation of a portion of the electrical circuit.

The invention further relates to a method for determining a status of the insulation of an electrical circuit in the above described electric generator. The method includes the steps of:

measuring a plurality of currents in the electrical circuit by using a plurality of current sensors,
calculating parameters depending on an impedance of at least a portion of said electrical circuit,
determining a status of the insulation of a portion of the electrical circuit.

According to embodiments of the electric generator of the present invention, the electrical circuit is a 3-phase circuit including at least a star connection of three coils wound on one of said segments, a sensor for measuring a current flowing in the coils being provided at the common neutral point of the three coils of said star connection, which can be considered as summation of 3-phase currents. According to other embodiments of the electric generator of the present invention, delta connections of three coils wound on one of said segments may be provided.

According to other embodiments of the electric generator of the present invention, a sensor for measuring a current flowing in the cable system or busbar system is provided in at least one cable or busbar of a cable system or busbar system of the electrical circuit.

The electric generator of the present invention may include a stator having a plurality of segments, each segment being associated with a respective current sensor of the electrical circuit for measuring a current flowing in the coil windings. Alternatively, the electrical circuit may include a plurality of pairs of coil windings connected in series, each pair comprising a respective current sensor of the electrical circuit for measuring a current flowing in the coil windings.

The current signals derived with the sensors positioned as above described are used in the controller of the electric generator and according to the method of the present invention for determining a status of the insulation of a portion of the electrical circuit, in particular a portion including the coil windings or the cable or busbar system.

The present invention provides a solution for online condition monitoring and protection of electric generators employed in wind turbines. This solution requires current measurements only, providing at the same time an improved sensitivity and a simpler, more effective and robust fault detection. The sensitivity may be particularly improved in embodiments using both amplitude and phase of the current measurements.

According to one embodiment of the method, the present invention includes monitoring partial discharge occurrence in the electrical circuit and comparing it with healthy partial discharge and patterns.

According to the method of the invention, the present invention includes measuring a plurality input current signals and deriving one or more diagnostic signals based on at least a difference of the input current signals. In such embodiments, the diagnostic signals may be derived from input current signals by extracting a plurality of harmonics from the input current signals or from at least a difference of the input current signals.

The method further includes monitoring a variation of a phase of the input current signals with respect to a reference angle signal. This allows determining a degradation of the complete insulation system if both current and phase remain equal between segments, but the phase varies over time with respect to a reference angle signal.

The aspects defined above and further aspects of the present invention are apparent from the examples of embodiment to be described hereinafter and are explained with reference to the examples of embodiment. The invention will be described in more detail hereinafter with reference to examples of embodiment but to which the invention is not limited.

Brief Description of the Drawings

Figure 1    shows a schematic section of a wind turbine including an electrical generator according to the present invention.

Figure 2    shows a schematic diagram of a first embodiment of an electric circuit included in the electrical generator of figure 1.

Figure 3    shows a schematic diagram of a second embodiment of an electric circuit included in the electrical generator of figure 1.

Figure 4    shows a schematic diagram of a third embodiment of an electric circuit included in the electrical generator of figure 1.

Figure 5    shows a schematic diagram of a fourth embodiment of an electric circuit included in the electrical generator of figure 1.

Figure 6    shows an electric scheme of an equivalent circuit representing the electrical insulation of a portion of the electric circuit included in the electrical generator of figure 1.

Figure 7    shows a functional block diagram of a controller of the electric generator of figure 1.

Figure 8    shows more details of one block of the diagram of figure 7.

Detailed Description

The illustrations in the drawings are schematic. It is noted that in different figures, similar or identical elements are provided with the same reference signs.

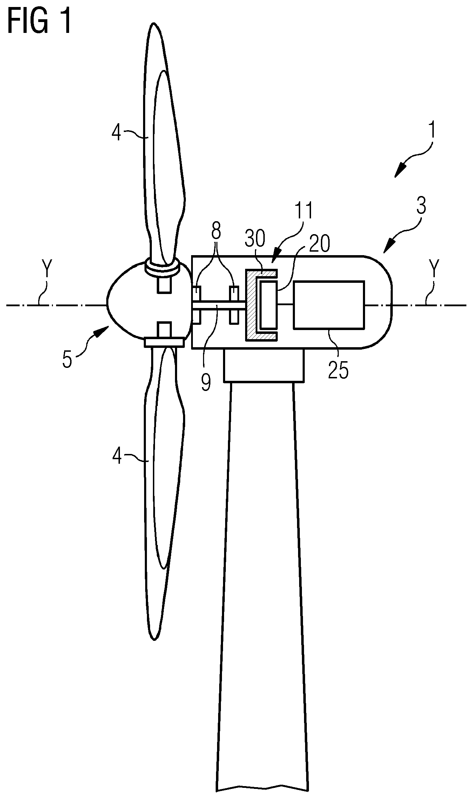

**Figure 1** shows a wind turbine 1 according to the invention. The wind turbine 1 comprises a tower 2, which is mounted on a non-depicted foundation. A nacelle 3 is arranged on top of the tower 2. The wind turbine 1 further comprises at least a wind rotor 5 having a hub and at least one blade 4 (in the embodiment of Figure 1, the wind rotor comprises three blades 4, of which only two blades 4 are visible). The wind rotor 5 is rotatable around a rotational longitudinal axis Y. The blades 4 extend substantially radially with respect to the longitudinal axis Y. In general, when not differently specified, the terms axial, radial and circumferential in the following are made with reference to the rotational longitudinal axis Y. The wind turbine 1 comprises at least one electric generator 11, including a stator 20 and a rotor 30. According to embodiments of the present inventio, the electric generator 11 may be a permanent magnet electric generator and have an external or internal rotor 30. The rotor 30 may include a plurality of permanent magnets, while the stator 20 may include a teeth-slots structure, where a plurality of coils is arranged. The stator may have a segmented structure including a plurality of circumferential segments circumferentially extending about a longitudinal axis Y about an arc measuring 360°/N, where N is the number of the segments. The rotor 30 is rotatable with respect to the stator 20 about the rotational longitudinal axis Y. The wind rotor 5 is coupled with the rotor 30 and both are connected to an outer ring of a main bearing assembly 8. The outer ring of the main bearing assembly 8 rotates about the rotational longitudinal axis Y with respect to a static inner ring, which is coupled with a main shaft 9 extending along the longitudinal axis Y. On a rear side of the nacelle 3, opposite to the wind rotor 5, a converter 25 is provided. The converter 25 electrically connected to the electrical generator 11 to transform the electrical output of the generator 11 to a certain predetermined power output at a predetermined voltage level to be provided to an electrical network, which is electrically connected to the transformer 25.

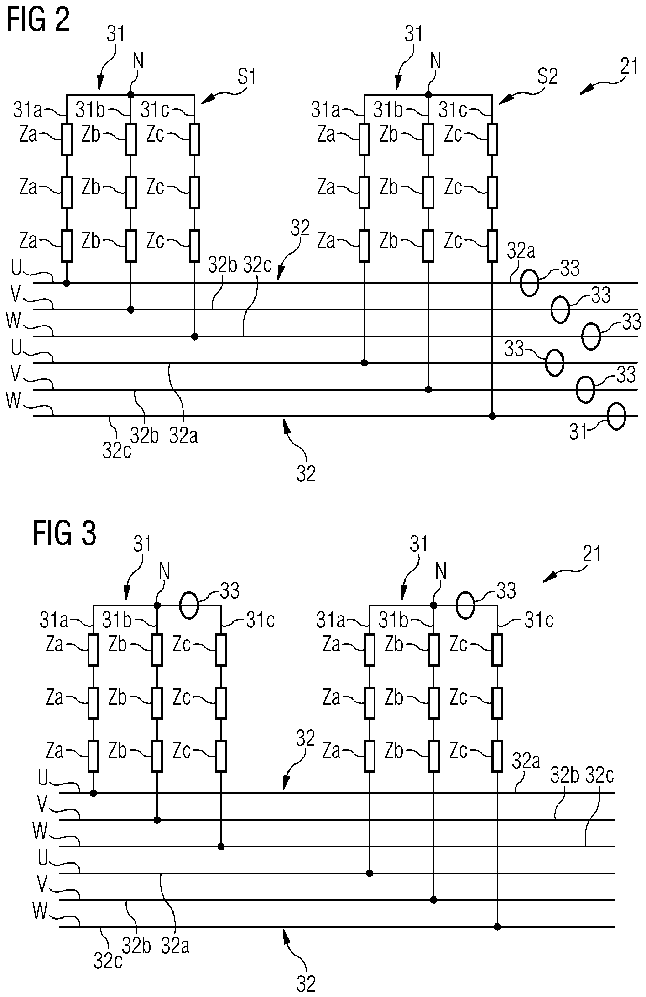

**Figure 2** shows an electrical circuit 21 associated with a stator 20 having a plurality of N segments S1, ..., SN circumferentially extending about a longitudinal axis Y of the stator 20 (in figure 2 only the two segments S1, S2 are represented, even if the stator 20 may in general have more than two segments). The electrical circuit 21 includes a plurality of N coil windings 31 respectively wound on the segments S1, ..., SN. The coil windings 31 may be of the concentrated or distributed type and includes a plurality of cable conductors including an insulation. The electrical circuit 21 is threephase circuit, each coil winding 31 comprising three respective coils 31a, 31b, 31c, each coil 31a, 31b, 31c being connected to a respective phase U, V, W. Each coil 31a, 31b, 31c may be represented through one or more impedances Za, Zb, Zc (three respective impedances are shown in figure 2 for each coil 31a, 31b, 31c). In each coil winding 31 the coils 31a, 31b, 31c are connected according to a star connection at a common neutral point N. The electrical circuit 21 further comprises a plurality of cable systems 32, each cable system comprising three cables 32a, 32b, 32c, respectively associated with the phases U, V, W. Alternatively, according to other possible embodiments of the present invention, instead of cable systems, the electrical circuit 21 comprises a plurality of busbar systems 32, each busbar system comprising three busbar 32a, 32b, 32c, respectively associated with the phases U, V, W. The electrical circuit 21 comprises at least one sensor 33 for measuring a current flowing in the electrical circuit 21. In the embodiment of figure 2, a current sensor 33 is provided on each of the three cable 32a, 32b, 32c (six sensors 33 are therefore shown in figure 2, in general being 3N the number of sensors comprised in the electrical circuit 21). Alternatively, according to other possible embodiments of the present invention (not shown), a sensor 33 may be provided in only one of the three cable 32a, 32b, 32c of each cable system 32 (therefore, N current sensor 33 in total). The current sensors 33 may be current transformer. According to possible embodiments of the present invention, the current transformers may be operating at a frequency comprised between 3 MHz and 300 MHz. Alternatively, according to other possible embodiments of the present invention, current sensors 33 may be common mode current sensors operating at a frequency comprised between 10 kHz to 900 kHz. The "common mode current" is the in-phase current flowing in the same direction on the multiple conductors which are comprised in each segment S1, ..., SN, for example included in the coils 31a, 31b, 31c. The electric generator 11 include a controller (not shown) for receiving a current measurement from the current sensors 33, parameters depending on an impedance of the electrical circuit 21 and determining a status of the insulation of the coil windings 31 based on such impedance calculations. The procedure for determining status of the insulation of the coil windings 31 is better detailed in the following.

**Figure 3** shows another embodiment of the electrical circuit 21. Differently from the embodiment of figure 2, the electrical circuit 21 comprises a current sensor 33 for measuring a current flowing in the coils 31a, 31b, 31c provided at each of the neutral point N (therefore, N current sensor 33 in total).

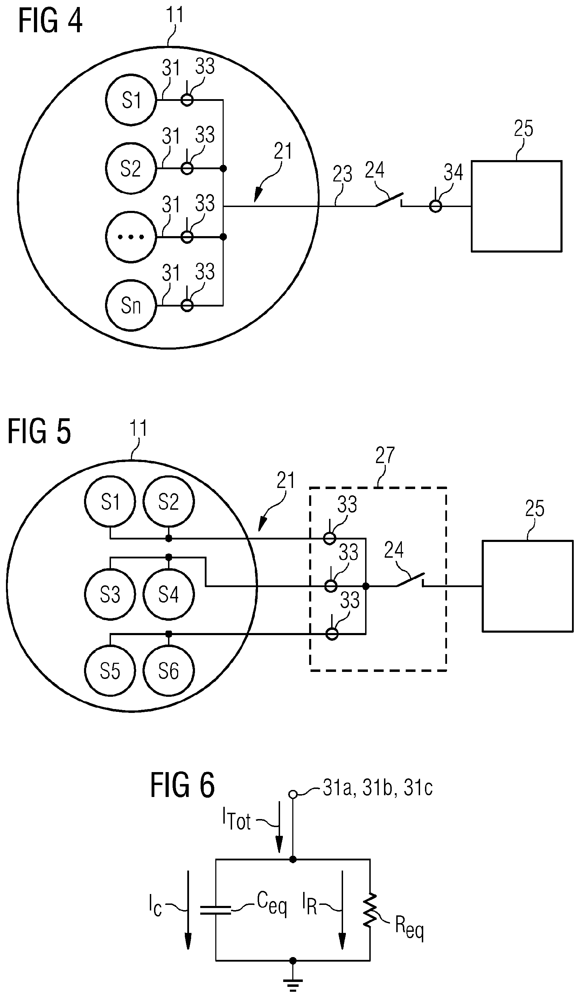

**Figure 4** shows an electric generator 11 including a stator having a plurality of N segments S1, ..., SN. To each segment S1, ..., SN it is associated a respective coil winding 31 having one respective current sensor 33. The coil windings 31 are connected in parallel to each other, each being connected to the converter 25 through a branch 23 of the electrical circuit 21. The branch 23 includes a circuit breaker 24 and a further current sensor 34 between the circuit breaker 24 and the converter 25. Each sensor 33 may be used to measure the common mode current in each segment S1, ..., SN.

**Figure 5** shows an electric generator 11 including a stator having a plurality of N segments S1, ..., SN, N being an even integer (N=6 in the embodiment represented in figure 5). To each segment S1, ..., SN it is associated a respective coil winding 31. The electrical circuit 21 comprises N/2 pairs (three pairs in the embodiment represented in figure 5) of coil windings 31, in each pair being the respective two coil windings 31 connected in series. The pairs of coil windings 31 are connected in parallel to each other, each pair being connected to the converter 25 through a circuit breaker cabinet 27. The circuit breaker cabinet 27 comprises N/2 current sensor 33 (each current sensor 33 being connected to a respective pair of coil windings 31) and a circuit breaker 24. The one-line connections in figures 4 and 5 represent threephase cables. Each sensor 33 may be used to measure the common mode current in each pair of segments S1,S2; S3,S4 and S5,S6.

**Figure 6** shows an electric scheme of the equivalent circuit 50 representing the electrical insulation of the coils 31a, 31b, 31c and the cable system 32. The electrical insulation is represented as an equivalent capacitance Ceq and an equivalent resistance Req, disposed in parallel between the conductor of the coils 31a, 31b, 31c or the cable system 32 and the ground. The total leakage current Itot flows in the equivalent circuit 50 and comprises a first portion Ic flowing in the equivalent capacitance Ceq and a second portion Ir in the equivalent resistance Req. The total leakage current It is given by:

$$\text{Itot} = \text{V} \ (1/\text{Req} + j\omega \text{Ceq})$$

Where V is the common mode voltage in the coils 31a, 31b, 31c or the cable system 32. The above expression makes it evident that a reduction of the insulation resistance leads to an increase of the leakage current amplitude, whereas a reduction of insulation capacitance leads to a decrease. Thus, when assuming V as constant, the variation of amplitude and/or phase of I over time is a result of the equivalent impedance variation. The diagnostic signals derived from the above expression of the leakage current It are well suited for fault detection, operating point independent and robust against false alarms. Alternatively, fault detection may include monitoring partial discharge occurrence in the coils 31a, 31b, 31c or the cable system 32 and comparing partial discharge occurrence with healthy partial discharge and patterns. Characterization for healthy partial discharge level and partial discharge pattern of the electric generator 11 in the field may be based on a previous monitoring or measurement experience.

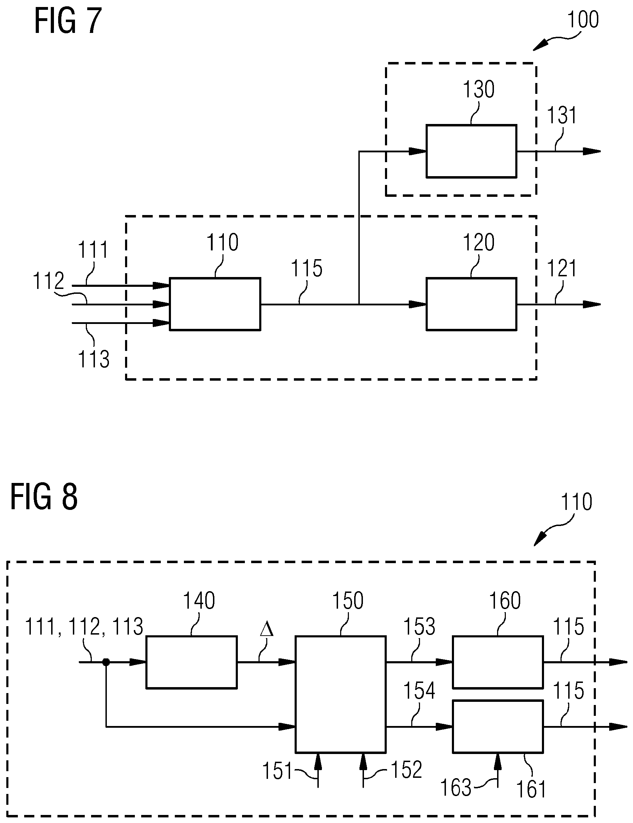

**Figure 7** shows a functional block diagram of a controller 100 of the electric generator. The controller 100 comprises an extraction block 110 for receiving a plurality raw input current signals 111, 112, 113 (three input signals are represented in figure 7, a different number of input signals being possible according to other embodiments of the invention) and deriving according to signal processing techniques one or more diagnostic signals 115. The feature extraction is carried out at relatively high sampling frequencies (tens to hundreds of kHz). The current signals 111, 112, 113 may be for example measurement signals produced by the three current sensors 33 shown in figure 5. The diagnostic signals 115 are provided to a fault detection block 120 which generates an alarm output signal 121 to enable a fast stop of the converter 25 in the presence of fast developing faults that exceed predefine critical threshold values derived from the raw input current signals 111, 112, 113 or a difference thereof, as better detailed in the following. The reaching of such threshold values corresponds to an unacceptable deterioration status of the insulation of the coil winding 31 or of the cable system 32. The fault detection may be at the same sampling rate of the feature extraction in the extraction block 110 (tens to hundreds of kHz) or lower (still in the range of kHz). The diagnostic signals 115 are also provided in parallel to a detection and prognostic block 130, normally realized as a SCADA (Supervisory Control and Data Acquisition) system which generates a diagnostic output 131 representing a health status and remaining useful life of the electrical insulation of the coils 31a, 31b, 31c. The fault detection block 120 and the detection and prognostic block 130 operates in parallel. The novelty detection and prognostic are done at much lower rates (sampling periods from seconds to minutes) with the aim to support predictive maintenance. The detection and prognostic block 130 may employ a fitted model and an outlier analysis as an example of novelty detection or alternatively more advanced machine learning techniques, in addition to a model-based estimation of the remaining useful life. In block 130 the diagnostic signals 115 may be combined with various other turbine/generator signals (e.g. speed, power, current, voltage, temperatures, etc.) for building a comprehensive model of the condition of the electric generator 11. Blocks 110, 120, 130 may be implemented as hardware or software components.

**Figure 8** shows more in detail the extraction block 110. Having measured the raw input common current signals 111, 112, 113, the differences between currents are calculated in the difference calculation block 140. Taking as an example three current signals coming from the three current sensor 33 of figure 5, two differences are calculated in the difference calculation block 140 as follows:

$$\Delta I_{12} = I_{111} - I_{112}$$

$$\Delta I_{31} = I_{113} - I_{111}$$

As opposed as to $I_{111}$, $I_{112}$ $I_{113}$ amplitudes, the amplitude of the differences $\Delta I_{12}$, $\Delta I_{31}$ are more operating point independent. Moreover, the differences are less sensitive to transients. Then, the harmonics of interest are selected by means of digital band-pass filters 150 (other techniques like DFT may be employed too). The band-pass filters 150 receives as input the differences $\Delta I_{12}$, $\Delta I_{31}$ calculated in the difference calculation block 140 and the raw input common current signals 111, 112, 113. Examples are harmonics of the switching frequency fc of the converter 25 or their side bands (±fundamental frequency fg of the electric generator 11), which are provided to the band-pass filters 150 as further inputs 151, 152, respectively. The harmonics calculated by the band-pass filters 150 may be k*fc, for odd multiples of fc (k=1,3,...) and k*fc + h*fg for even multiples of fc(k=2,4,...), where h*fg are integer harmonics of the generator fundamental electrical frequency (h=±1, ±3, ±5, ...). Odd multiples of fc may be preferred due to their independence on the generator fundamental electrical frequency. Finally, it is desirable to provide the fault detection block 120 and the detection and prognostic block 130 with diagnostic signals 115 that are mainly DC signals. This is achieved by calculating amplitude and phase of the harmonic signals in the first calculation block 160 and in the second calculation block 161, respectively receiving as input the harmonics of the current differences 153 and the harmonics of the currents signals 154 calculated by the band-pass filters 150. The first calculation block 160 generates diagnostic signals 115 corresponding to amplitudes of the harmonics of the current differences. The second calculation block 161 generates diagnostic signals 115 corresponding to amplitudes and phases of the current harmonics. The amplitude values of the measured currents and their differences are the primary diagnostic signals, whereas the phase is optional. To calculate the phase from the harmonic the amplitude and phase calculation block 161 receives as further a phase signal 163, representing a phase of the electric generator 11.

The variation over time of the diagnostic signals 115, which is identified in the fault detection block 120 and the detection and prognostic block 130, provides an indication of the degradation of the insulation of the coils 31a, 31b, 31c. Fault detection may be done by evaluating the error between the actual values of the diagnostic signals and their initial values considered as a reference for healthy conditions. The fact that signals from multiple segments S1, S2,...., SN are available eases location of an identified fault. Voltage measurements are not required, when all segments are excited by the same common mode voltage. Faults are localized by analyzing variation of the current differences. Considering the embodiment of figure 5, $\Delta I_{12}$ permits to analyze information from a first current signal 111 and a second current signal 112, while the $\Delta I_{31}$ permits to analyze information from the first current signal 111 and a third current signal 113. Ageing of the electrical insulation may result in little variation of the amplitude of the current differences ($\Delta I$), thus being required to have at least one diagnostic signal 115 corresponding to the amplitude of at least one current signal 111, 112, 113.

Concerning the phase information in the leakage current It, the ratio between IR and IC is typically used to derive the so-called dissipation factor:

$$\tan\delta = |Ir|/|Ic| = 1/(\omega ReqCeq)$$

Thus, even though the amplitude of the leakage current remains constant, a change in $\delta$ indicates a change in the insulation equivalent impedance. For example, at insulation degradation with both or either of the resistance Req and capacitance Ceq being decreased, the dissipation factor will be increased, and the excitation frequency may provide a freedom of design for improvement of discrimination sensitivity. The angle $\delta$ may also be given as:

$$\delta = \cos^{-1}(|Ic|/|Itot|)$$

The relative change of the angle $\delta$ may be additionally or alternatively used for indication of an insulation degradation. Firstly, it is assumed that the current amplitude (|Itot|)remains unchanged for two pairs of segments (for example the pair of segment S1, S2 and the pair of segments S3, S4 shown in figure 5), whereas $\delta$ varies in a faulty segment pair, this resulting in different phase angles $\delta1$ and $\delta2$. The corresponding currents $I_{111}$ and $I_{112}$ may be represented as:

$$I_{111}(t) = |I|\cos(\omega t+\pi/2- \delta1)$$

$$I_{112}(t) = |I|\cos(\omega t+\pi/2- \delta2)$$

And the amplitude of the error $\Delta I_{12}$ between $I_{111}$ and $I_{112}$ increases with the increase of $|\delta2 - \delta1|$, as evident from:

$$\Delta I_{12}(t)=I_{111}(t)-I_{112}(t)=-2|I|\sin((\delta2-\delta1)/2)\sin(\omega t+\pi/2-(\delta1\ \delta2)/2).$$

The amplitude of the error $\Delta I_{12}(t)$ contains therefore information on $\delta$ only if this differs between segments. On the other hand, if both |I| and $\delta$ remain equal between segments, but $\delta$ varies over times (even degradation of the complete insulation system), there is the need to calculate $\delta$ variation with respect to a reference signal. Variations of $\delta$ can be calculated with respect to an angle that is readily available from the electric generator 11 or the converter 25, for example the generator rotor position (signal 163 provided to the phase calculation block 161, as shown in figure 8), and/or the angle of the carrier signal of the converter 25 and/or the angle of an estimated common mode voltage. Any other known angle signal may be used as a reference.

**Claims**

1. An electric generator (11) for a wind turbine (1) including:

   a stator (20) having a plurality of segments (S1, ..., SN) circumferentially extending about a longitudinal axis (Y) of the stator (20),
   an electrical circuit (21) associated with said segments (S1, ..., SN), the electrical circuit (21) including a plurality of coil windings (31) respectively wound on said segments (S1, ..., SN), each coil winding (31) including an electrical insulation,
   wherein the electrical circuit (21) comprises a plurality of current sensors (33) for measuring currents flowing in the electrical circuit (21),
   wherein the electric generator (11) includes a controller (100) for receiving current signals (111, 112, 113) from said current sensors (33), calculating parameters depending on an impedance of at least a portion of said electrical circuit (21), determining a status of the insulation of a portion of the electrical circuit (21),
   wherein
   each segment (S1, ..., SN) is associated with a respective current sensor (33) of the electrical circuit (21) for measuring a current flowing in the coil windings (31) and determining a status of the insulation of the electrical circuit (21); **characterised in that**
   the controller (100) comprises an extraction block (110), the extraction block (110) comprising a difference calculation block (140) configured to calculate a difference ($\Delta$) of the input current signals (111, 112, 113), a band-pass filter (150) configured to calculate harmonics (153) of the difference ($\Delta$) of the input current signals (111, 112, 113), and a first calculation block (160) configured to generate a diagnostic signal (115) based on amplitudes of the harmonics (153); and/or
   the controller (100) comprises an extraction block (110), the extraction block (110) comprising a band-pass filter (150) configured to calculate harmonics (154) of the input current signals (111, 112, 113), and a second calculation block (161) configured to calculate a variation of a phase ($\delta$) of the harmonics (154) with respect to a reference angle signal (163) and to generate a diagnostic signal (115) based on the variation.

2. The electric generator (11) according to claim 1, wherein the electrical circuit (21) is a 3-phase circuit including at least a star connection of three coils (31, 31b, 31c) wound on one of said segments (S1, ..., SN), a sensor (33) of said plurality of sensor (33) for measuring a current flowing in the coils (31a, 31b, 31c) being provided at the neutral point (N) of the three coils (31, 31b, 31c) of said star connection.

3. The electric generator (11) according to claim 1, wherein the electrical circuit (21) is a 3-phase circuit including at least a cable system (32) or busbar system, a sensor (33) of said plurality of sensor (33) for measuring a current flowing in the cable system or busbar system being provided in at least one cable (32a, 32b, 32c) or busbar of the cable system (32) or busbar system.

4. The electric generator (11) according to claim 3, wherein a cable system (32) or busbar system includes three cables (32a, 32b, 32c) or busbars, three current sensors (33) of said plurality of sensor (33) for measuring a current flowing in the cable system (32) or busbar system being respectively provided in each of said three cables or busbars.

5. The electric generator (11) according to any of the previous claim 1, wherein the electrical circuit (21) includes a plurality of pairs of coil windings (31) connected in series, each pair comprising a respective current sensor (33) of said plurality of sensor (33) for measuring a current flowing in the coil windings (31).

6. The electric generator (11) according to any of the previous claims, wherein the at least one current sensor (33) of said plurality of sensor (33) for measuring a current flowing in the electrical circuit (21) is a current transformer operating at a frequency comprised between 3 MHz and 300 MHz.

7. The electric generator (11) according to any of the previous claims 1 to 5, wherein at least one current sensor (33) of said plurality of sensor (33) is for measuring a common mode current flowing in the electrical circuit (21) of each parallel branch and operating at a frequency comprised between 10 kHz to 900 kHz.

8. A method for determining a status of the insulation of an electrical circuit (21) in an electric generator (11) according to any of the previous claims, the method including the steps of:

   measuring a plurality of currents in the electrical circuit (21) by using the plurality of current sensor (33),

calculating parameters depending on an impedance of at least a portion of said electrical circuit (21), determining a status of the insulation of at least a portion of the electrical circuit (21);

measuring a plurality input current signals (111, 112, 113) and deriving one or more diagnostic signals (115) wherein the diagnostic signals (115) are derived from input current signals (111, 112, 113) by calculating a difference ($\Delta$) of the input current signals (111, 112, 113), extracting a plurality of harmonics (153, ) of the difference ($\Delta$) of the input current signals (111, 112, 113) and calculating amplitudes of the harmonics (153), or

wherein the diagnostic signals (115) are derived from input current signals (111, 112, 113) by extracting a plurality of harmonics (154) of the input current signals (111, 112, 113) and monitoring a variation of a phase ($\delta$) of the input current signals (111, 112, 113) with respect to a reference angle signal (163).

9. The method of claim 8, wherein the method includes monitoring partial discharge occurrence in the electrical circuit (21) and comparing partial discharge occurrence with healthy partial discharge and patterns.

10. The method of claim 9, wherein the plurality of harmonics is extracted in a plurality of digital band-pass filters (150).

11. The method of any of the claims 8 to 10, wherein an alarm signal (121) is generated when a predefined critical threshold value derived from the input current signals (111, 112, 113) or on a difference ($\Delta$) of the input current signals (111, 112, 113) is reached.

12. The method of the claims 8 and 10, wherein the generator insulation health status is tracked over time, thus providing indication of its lifetime.

**Patentansprüche**

1. Elektrischer Generator (11) für eine Windenergieanlage (1), der Folgendes beinhaltet:

einen Stator (20) mit mehreren Segmenten (S1, **...,** SN), die sich umfangsmäßig um eine Längsachse (Y) des Stators (20) erstrecken, eine elektrische Schaltung (21), die den Segmenten (S1, **...,** SN) zugeordnet ist, wobei die elektrische Schaltung (21) mehrere Spulenwicklungen (31) beinhaltet, die jeweils auf die Segmente (S1, **...,** SN) gewickelt sind, wobei jede Spulenwicklung (31) eine elektrische Isolierung beinhaltet,

wobei die elektrische Schaltung (21) mehrere Stromsensoren (33) zum Messen von Strömen umfasst, die in der elektrischen Schaltung (21) fließen,

wobei der elektrische Generator (11) eine Steuerung (100) zum Empfangen von Stromsignalen (111, 112, 113) von den Stromsensoren (33), Berechnen von Parametern in Abhängigkeit von einer Impedanz mindestens eines Teils der elektrischen Schaltung (21), Bestimmen eines Status der Isolation eines Teils der elektrischen Schaltung (21) beinhaltet, wobei

jedem Segment (S1, **...,** SN) jeweils ein Stromsensor (33) der elektrischen Schaltung (21) zugeordnet ist, um einen in den Spulenwicklungen (31) fließenden Strom zu messen und einen Status der Isolation der elektrischen Schaltung (21) zu bestimmen; **dadurch gekennzeichnet, dass**

die Steuerung (100) einen Extraktionsblock (110) umfasst, wobei der Extraktionsblock (110) einen Differenzberechnungsblock (140), der dazu ausgelegt ist, eine Differenz ($\Delta$) der Eingangsstromsignale (111, 112, 113) zu berechnen, ein Bandpassfilter (150), das dazu ausgelegt ist, Oberwellen (153) der Differenz ($\Delta$) der Eingangsstromsignale (111, 112, 113) zu berechnen, und einen ersten Berechnungsblock (160), der dazu ausgelegt ist, ein Diagnosesignal (115) basierend auf den Amplituden der Oberwellen (153) zu erzeugen, umfasst, und/oder

die Steuerung (100) einen Extraktionsblock (110) umfasst, wobei der Extraktionsblock (110) ein Bandpassfilter (150) umfasst, das dazu ausgelegt ist, Oberwellen (154) der Eingangsstromsignale (111, 112, 113) zu berechnen, und einen zweiten Berechnungsblock (161), der dazu ausgelegt ist, eine Variation einer Phase ($\delta$) der Oberwellen (154) in Bezug auf ein Referenzwinkelsignal (163) zu berechnen und ein Diagnosesignal (115) basierend auf der Variation zu erzeugen.

2. Elektrischer Generator (11) nach Anspruch 1, wobei die elektrische Schaltung (21) eine 3-Phasen-Schaltung ist, die mindestens eine Sternverbindung von drei Spulen (31, 31b, 31c) beinhaltet, die auf eines der Segmente (S1, ..., SN) gewickelt sind, wobei ein Sensor (33) der mehreren Sensoren (33) zum Messen eines Stroms, der in den Spulen (31a, 31b, 31c) fließt, am Neutralpunkt (N) der drei Spulen (31, 31b, 31c) der Sternverbindung bereitgestellt ist.

3. Elektrischer Generator (11) nach Anspruch 1, wobei die elektrische Schaltung (21) eine 3-Phasen-Schaltung ist, die mindestens ein Kabelsystem (32) oder ein Sammelschienensystem beinhaltet, wobei ein Sensor (33) der mehreren Sensoren (33) zum Messen eines Stroms, der in dem Kabelsystem oder dem Sammelschienensystem fließt, in mindestens einem Kabel (32a, 32b, 32c) oder einer Sammelschiene des Kabelsystems (32) oder des Sammelschienensystems bereitgestellt ist.

4. Elektrischer Generator (11) nach Anspruch 3, wobei ein Kabelsystem (32) oder ein Sammelschienensystem drei Kabel (32a, 32b, 32c) oder Sammelschienen beinhaltet, wobei drei Stromsensoren (33) der mehreren Sensoren (33) zum Messen eines Stroms, der in dem Kabelsystem (32) oder dem Sammelschienensystem fließt, jeweils in jedem der drei Kabel oder Sammelschienen bereitgestellt sind.

5. Elektrischer Generator (11) nach einem des vorhergehenden Anspruchs 1, wobei die elektrische Schaltung (21) mehrere Paare von Spulenwicklungen (31) beinhaltet, die in Reihe geschaltet sind, wobei jedes Paar einen jeweiligen Stromsensor (33) der mehreren Sensoren (33) zum Messen eines Stroms umfasst, der in den Spulenwicklungen (31) fließt.

6. Elektrischer Generator (11) nach einem der vorhergehenden Ansprüche, wobei der mindestens eine Stromsensor (33) der mehreren Sensoren (33) zum Messen eines in der elektrischen Schaltung (21) fließenden Stroms ein Stromwandler ist, der mit einer Frequenz arbeitet, die zwischen 3 MHz und 300 MHz umfasst.

7. Elektrischer Generator (11) nach einem der vorhergehenden Ansprüche 1 bis 5, wobei mindestens ein Stromsensor (33) der mehreren Sensoren (33) zum Messen eines Gleichtaktstroms dient, der in der elektrischen Schaltung (21) jedes parallelen Zweigs fließt und mit einer Frequenz arbeitet, die zwischen 10 kHz und 900 kHz umfasst.

8. Verfahren zum Bestimmen eines Status der Isolation einer elektrischen Schaltung (21) in einem elektrischen Generator (11) nach einem der vorhergehenden Ansprüche, wobei das Verfahren die folgenden Schritte beinhaltet:

Messen mehrerer Ströme in der elektrischen Schaltung (21) unter Verwendung der mehreren Stromsensoren (33),
Berechnen von Parametern in Abhängigkeit von einer Impedanz mindestens eines Teils der elektrischen Schaltung (21),
Bestimmen eines Status der Isolation mindestens eines Teils der elektrischen Schaltung (21);
Messen mehrerer Eingangsstromsignale (111, 112, 113) und Ableiten eines oder mehrerer Diagnosesignale (115);
wobei die Diagnosesignale (115) von Eingangsstromsignalen (111, 112, 113) durch Berechnen einer Differenz ($\Delta$) der Eingangsstromsignale (111, 112, 113), Extrahieren mehrerer Oberwellen (153) der Differenz ($\Delta$) der Eingangsstromsignale (111, 112, 113) und Berechnen von Amplituden der Oberwellen (153) abgeleitet werden, oder wobei die Diagnosesignale (115) von Eingangsstromsignalen (111, 112, 113) durch Extrahieren mehrerer Oberwellen (154) der Eingangsstromsignale (111, 112, 113) und Überwachen einer Variation einer Phase ($\delta$) der Eingangsstromsignale (111, 112, 113) in Bezug auf ein Referenzwinkelsignal (163) abgeleitet werden.

9. Verfahren nach Anspruch 8, wobei das Verfahren das Überwachen des Auftretens einer partiellen Entladung in der elektrischen Schaltung (21) und das Vergleichen des Auftretens einer partiellen Entladung mit einer gesunden partiellen Entladung und Mustern beinhaltet.

10. Verfahren nach Anspruch 9, wobei die mehreren Oberwellen in mehreren digitalen Bandpassfiltern (150) extrahiert werden.

11. Verfahren nach einem der Ansprüche 8 bis 10, wobei ein Alarmsignal (121) erzeugt wird, wenn ein vordefinierter kritischer Schwellenwert, der aus den Eingangsstromsignalen (111, 112, 113) oder einer Differenz ($\Delta$) der Eingangsstromsignale (111, 112, 113) abgeleitet wird, erreicht wird.

12. Verfahren nach den Ansprüchen 8 und 10, wobei der Gesundheitszustand der Generatorisolation im Laufe der Zeit verfolgt wird, wodurch eine Angabe seiner Lebensdauer bereitgestellt wird.

## Revendications

1. Générateur électrique (11) pour une éolienne (1) incluant :

un stator (20) ayant une pluralité de segments (S1, ..., SN) s'étendant de manière circonférentielle autour d'un axe longitudinal (Y) du stator (20),

un circuit électrique (21) associé auxdits segments (S1, ..., SN), le circuit électrique (21) incluant une pluralité d'enroulements de bobine (31) respectivement enroulés sur lesdits segments (S1, ..., SN), chaque enroulement de bobine (31) incluant une isolation électrique,

dans lequel le circuit électrique (21) comprend une pluralité de capteurs de courant (33) pour la mesure de courants circulant dans le circuit électrique (21),

dans lequel le générateur électrique (11) inclut un dispositif de commande (100) pour la réception de signaux de courant (111, 112, 113) provenant desdits capteurs de courant (33), le calcul de paramètres dépendant d'une impédance d'au moins une partie dudit circuit électrique (21), la détermination d'un état de l'isolation d'une partie du circuit électrique (21), dans lequel

chaque segment (S1, ..., SN) est associé à un capteur de courant (33) respectif du circuit électrique (21) pour la mesure d'un courant circulant dans les enroulements de bobine (31) et la détermination d'un état de l'isolation du circuit électrique (21) ;

**caractérisé en ce que**

le dispositif de commande (100) comprend un bloc d'extraction (110), le bloc d'extraction (110) comprenant un bloc de calcul de différence (140) configuré pour calculer une différence (∆) des signaux de courant d'entrée (111, 112, 113), un filtre passe-bande (150) configuré pour calculer des harmoniques (153) de la différence (∆) des signaux de courant d'entrée (111, 112, 113), et un premier bloc de calcul (160) configuré pour générer un signal de diagnostic (115) sur la base d'amplitudes des harmoniques (153) ; et/ou

le dispositif de commande (100) comprend un bloc d'extraction (110), le bloc d'extraction (110) comprenant un filtre passe-bande (150) configuré pour calculer des harmoniques (154) des signaux de courant d'entrée (111, 112, 113), et un second bloc de calcul (161) configuré pour calculer une variation d'une phase (δ) des harmoniques (154) par rapport à un signal d'angle de référence (163) et pour générer un signal de diagnostic (115) sur la base de la variation.

2. Générateur électrique (11) selon la revendication 1, dans lequel le circuit électrique (21) est un circuit triphasé incluant au moins une connexion en étoile de trois bobines (31, 31b, 31c) enroulées sur l'un desdits segments (S1, ..., SN), un capteur (33) de ladite pluralité de capteurs (33) pour la mesure d'un courant circulant dans les bobines (31a, 31b, 31c) étant ménagé au point neutre (N) des trois bobines (31, 31b, 31c) de ladite connexion en étoile.

3. Générateur électrique (11) selon la revendication 1, dans lequel le circuit électrique (21) est un circuit triphasé incluant au moins un système de câbles (32) ou un système de barres omnibus, un capteur (33) de ladite pluralité de capteurs (33) pour la mesure d'un courant circulant dans le système de câbles ou le système de barres omnibus étant ménagé dans au moins un câble (32a, 32b, 32c) ou une barre omnibus du système de câbles (32) ou du système de barres omnibus.

4. Générateur électrique (11) selon la revendication 3, dans lequel un système de câbles (32) ou un système de barres omnibus inclut trois câbles (32a, 32b, 32c) ou barres omnibus, trois capteurs de courant (33) de ladite pluralité de capteurs (33) pour la mesure d'un courant circulant dans le système de câbles (32) ou le système de barres omnibus étant respectivement ménagés dans chacun desdits trois câbles ou chacune desdites trois barres omnibus.

5. Générateur électrique (11) selon l'une quelconque de la revendication 1 précédente, dans lequel le circuit électrique (21) inclut une pluralité de paires d'enroulements de bobine (31) connectés en série, chaque paire comprenant un capteur de courant (33) respectif de ladite pluralité de capteurs (33) pour la mesure d'un courant circulant dans les enroulements de bobine (31).

6. Générateur électrique (11) selon l'une quelconque des revendications précédentes, dans lequel l'au moins un capteur de courant (33) de ladite pluralité de capteurs (33) pour la mesure d'un courant circulant dans le circuit électrique (21) est un transformateur de courant fonctionnant à une fréquence comprise entre 3 MHz et 300 MHz.

7. Générateur électrique (11) selon l'une quelconque des revendications 1 à 5 précédentes, dans lequel au moins un capteur de courant (33) de ladite pluralité de capteurs (33) est destiné à la mesure d'un courant de mode commun circulant dans le circuit électrique (21) de chaque branche parallèle et fonctionnant à une fréquence comprise entre 10 kHz et 900 kHz.

8. Procédé pour la détermination d'un état de l'isolation d'un circuit électrique (21) dans un générateur électrique (11) selon l'une quelconque des revendications précédentes, le procédé incluant les étapes de :

la mesure d'une pluralité de courants dans le circuit électrique (21) en utilisant la pluralité de capteurs de courant (33),

le calcul de paramètres dépendant d'une impédance d'au moins une partie dudit circuit électrique (21),

la détermination d'un état de l'isolation d'au moins une partie du circuit électrique (21) ;

la mesure d'une pluralité de signaux de courant d'entrée (111, 112, 113) et la déduction d'un ou de plusieurs signaux de diagnostic (115) ;

dans lequel les signaux de diagnostic (115) sont déduits de signaux de courant d'entrée (111, 112, 113) par le calcul d'une différence ($\Delta$) des signaux de courant d'entrée (111, 112, 113), l'extraction d'une pluralité d'harmoniques (153) de la différence ($\Delta$) des signaux de courant d'entrée (111, 112, 113) et le calcul d'amplitudes des harmoniques (153), ou

dans lequel les signaux de diagnostic (115) sont déduits de signaux de courant d'entrée (111, 112, 113) par l'extraction d'une pluralité d'harmoniques (154) des signaux de courant d'entrée (111, 112, 113) et la surveillance d'une variation d'une phase ($\delta$) des signaux de courant d'entrée (111, 112, 113) par rapport à un signal d'angle de référence (163).

9. Procédé selon la revendication 8, dans lequel le procédé inclut la surveillance d'une occurrence de décharge partielle dans le circuit électrique (21) et la comparaison de l'occurrence de décharge partielle avec une décharge partielle saine et des profils.

10. Procédé selon la revendication 9, dans lequel la pluralité d'harmoniques est extraite dans une pluralité de filtres passe-bande numériques (150).

11. Procédé selon l'une quelconque des revendications 8 à 10, dans lequel un signal d'alarme (121) est généré lorsqu'une valeur seuil critique prédéfinie déduite des signaux de courant d'entrée (111, 112, 113) ou sur une différence ($\Delta$) des signaux de courant d'entrée (111, 112, 113) est atteinte.

12. Procédé selon les revendications 8 et 10, dans lequel l'état de santé d'isolation du générateur est suivie au cours du temps, ce qui fournit une indication de sa durée de vie.

FIG 1

FIG 2

FIG 3

EP 3 879 282 B1

## FIG 4

## FIG 5

## FIG 6

FIG 7

FIG 8

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2018011133 A1